# EUROPEAN PATENT APPLICATION

(11) **EP 2 492 242 A1**
(43) Date of publication of application: **29.08.2012**
(21) Application number: 10824780.0
(22) Date of filing: 04.10.2010
(51) Int. Cl.: C01B 33/02, C01B 33/06, F27B 14/04, F27B 14/06

(54) **FURNACE FOR MELTING SILICON OR SILICON ALLOY**

(30) Priority: 19.10.2009 JP 2009240340
(71) Applicant: JX Nippon Mining & Metals Corporation, Tokyo 100-8164 (JP)
(72) Inventor: TAKAMURA Hiroshi, Kitaibaraki-shi Ibaraki 319-1535 (JP); NARITA Satoyasu, Kitaibaraki-shi Ibaraki 319-1535 (JP)
(74) Representative: Hoarton, Lloyd Douglas Charles
(86) International application number: PCT/JP2010/067336
(87) International publication number: WO 2011/048931

(57) **Abstract**

A method and a furnace for melting a silicon or silicon-based alloy raw material, wherein the raw material is heated with a heating element that generates heat via energization, and the raw material is melted in an inert atmosphere with an oxygen partial pressure of 1 to 1000 Pa. Specifically, provided are a melting method and a melting furnace for melting a silicon or silicon-based alloy in a furnace that does not need to be a high vacuum by changing the material of a conventionally used heater. In addition, the inclusion of impurities is prevented by changing the material of the heater or insulator as needed. A monocrystalline or polycrystalline silicon or silicon-based alloy can thereby be produced at low cost.

## Description

### TECHNICAL FIELD

The present invention relates to a melting method and a melting furnace capable of melting a silicon or silicon alloy raw material at low cost.

### BACKGROUND ART

Demands for silicon have been increasing sharply in recent years for use as a semiconductor substrate or a solar cell material. Monocrystalline silicon is used as the semiconductor substrate (wafer), and the original monocrystalline ingot is prepared via the Czochralski method (Cz method) or the floating zone method (FZ method).
Meanwhile, with Si for use in solar cells, there are cases where monocrystalline silicon is used as with semiconductors and cases where polycrystalline silicon is used. The monocrystalline silicon is superior in terms of energy conversion efficiency, but the polycrystalline silicon that can be prepared via melting and casting is advantageous in terms of production cost since it can be produced with low cost, and these two types of silicon are creatively used according to their usage.
The foregoing crystalline silicon is the main trend for use in solar cells even though solar cells of various systems are being developed, and exploding demands are also expected in the future. Meanwhile, in order to diffuse solar cells globally, demands for further cost reduction are increasing with severity.

In the production of polycrystalline silicon ingots, polysilicon (metal Si) as the raw material is simply melted and solidified, which is why it is sometimes considered easy compared to monocrystalline silicon that is prepared by aligning the crystal orientation and which must be free of defects. Nevertheless, the current situation is that, even for use in solar cells in which the specification is said to be less strict compared to use in semiconductors, strict control of quality is required to prevent cast defects such as shrinkage cavities and voids from being generated within the ingot, and reduce the impurities since the abundance of impurities will lead to adverse effects in the conversion efficiency. Thus, a device for producing this kind of silicon ingot is extremely expensive.

The existing polycrystalline melting furnace is dramatically superior than the monocrystalline growth unit in terms of the processing speed and production capacity of the Si ingot in a single device. However, when investing in equipment for the further expansion of production, costs will increase in proportion to the enlargement in size as with, or even more than, the monocrystalline growth unit, and the cost reduction of crystalline silicon has come to a halt when considering the burden of amortization expenses and the like.
As another factor which causes the polycrystalline silicon melter to be extremely expensive is that high vacuum processing is performed before and during the melting of the metal Si raw material, in existing conditions. The common practice is that initial pumping is foremost performed in a high vacuum in order to eliminate the moisture and impurities that have adhered to the raw material and peripheral materials including the crucible. In order to perform this high vacuum processing, a pressure tight case (tank) and pumps are required. The pressure-tight tank needs to be designed thick, and, as its size is enlarged, material costs will increase, and additional costs are required for attaining a perfect weld to prevent leaks.

Moreover, with the pumps also, a plurality of types; for instance, a rotary pump, a mechanical booster pump, an oil spreading pump, a turbo-molecular pump need to be combined to obtain a high vacuum, which increase costs. In addition, a cooling function is provided to the side face or the cover part of the furnace body in order to cool the furnace body in preparation for the high temperature treatment during the Si melting or the like. As the cooling function, there are types where a water channel is provided inside the tank, and a jacket type that is mounted on the surface of the furnace. In present circumstances, most of the Si melting furnaces possess this cooling function, and this function is a burden including the ensurement of utility of the coolant.
In order to prevent the generation of shrinkage cavities and voids in the ingot, various devisals have been proposed such as the rotation and raising/lowering of the crucible, mounting of a ceiling heater, raising/lowering of the heater position, and so on. The provision of these functions while ensuring the airtightness to achieve a high vacuum inside the furnace also caused the facility costs to be expensive.

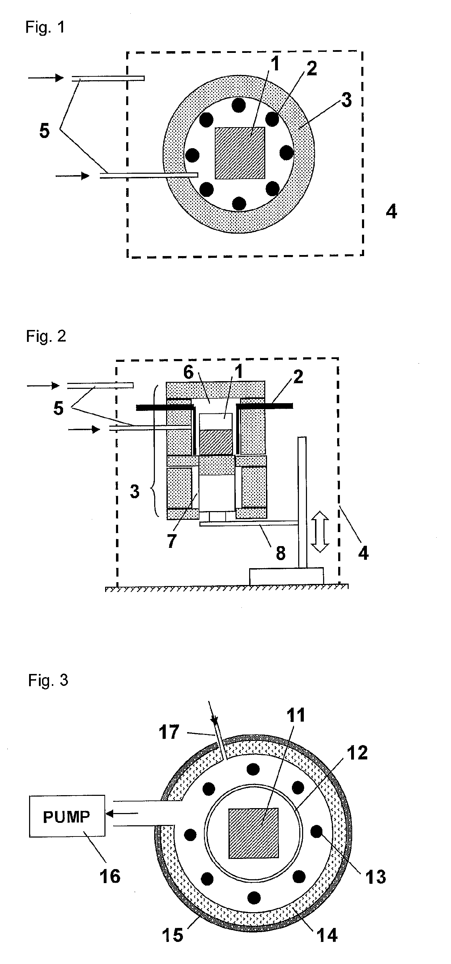

By way of reference, the melting method in a conventional resistance heating furnace is now explained with reference to a cross section upon viewing the furnace from directly above. Fig. 3 shows an example of a vacuum furnace, and a cylindrical heat-resistant bulkhead 12 is provided around a silicon melting crucible 11, and a carbon heater 13 is disposed around the bulkhead 12. This bulkhead 12 is used for preventing the contamination of carbon from a heater 13, which is heated to a temperature that is higher than the furnace temperature and which has a high vapor pressure, to the molten silicon, and uniformly heating the melting crucible.
A heat-resistance pressure tight case 14 is disposed at the outer periphery of the heater 13. A rolled steel (SS) or stainless steel (SUS) for general structure is used as the material of the foregoing pressure tight case 14. A cooling unit 15 such as a water-cooling jacket or a water-cooling channel is mounted around or near the surface layer of the pressure tight case 14 in order to prevent damage caused by the high heat of the pressure tight case 14 and inhibit the generation of heat to the outside. A vacuum pump 16 is connected to the pressure tight case 14, and inert gas is introduced from a piping 17 and at the same time the inside of the pressure tight case 14 is pumped.

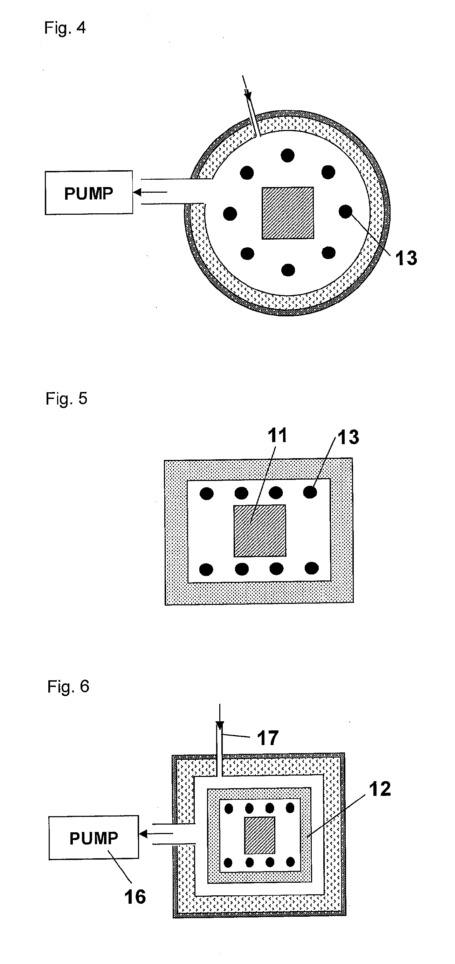

Fig. 4 shows another example of a conventional vacuum case. Here, an example of using molybdenum or tungsten as the material of the heater 13 is shown, and in this case the bulkhead 12 shown in Fig. 3 is not required since there will be no contamination of carbon to the molten silicon. The structure is simplified compared to Fig. 3. Nevertheless, in the foregoing case, carbon is sometimes used as the material of the heater if there is no particular problem related to the carbon contamination.
The degree of vacuum upon using a vacuum case depends on the type of pump, and the oxygen partial pressure is set to roughly 0.14 Pa when using a rotary pump, the oxygen partial pressure is set to roughly 0.03 Pa when using a mechanical booster pump, and the oxygen partial pressure is set to roughly 0.00002 Pa when using an oil spreading pump. In all of these cases, however, an expensive vacuum pump must be used, and there is a problem in that the facility costs and maintenance and operation costs become expensive.

Fig. 5 shows an example of a conventional high-temperature air atmosphere furnace. Here, a heater 13 made of molybdenum silicide (MoSi₂) or silicon carbide (SiC) is often used around a heat-treated crucible 11, although it is not used for melting the silicon.
Moreover, an insulator material such as a ceramic fiber board is generally used for the outer wall of the furnace. Since a ceramic fiber board has extremely low thermal conductivity and high heat insulating effect, there are cases where, if it is designed to be sufficiently thick, a water-cooling function is not required. The structure of the furnace is extremely simple compared to the structure of Fig. 3 and Fig. 4, and it is easier to achieve low cost.
Nevertheless, as a matter of course, oxidation of the melt cannot be inhibited since the ceramic fiber board is exposed to the air atmosphere. Generally, a high-temperature air atmosphere furnace is used for melting a material in which the oxidation of the melt is of no concern, or a material that has already been oxidized. The oxygen concentration in the foregoing case is 21%, and the oxygen partial pressure reaches approximately 21,000 Pa.

Fig. 6 shows a versatile melting furnace, and has a structure where the air atmosphere furnace of Fig. 5 is enclosed by a pressure-tight tank. In accordance with the material to be melted, a versatile melting furnace can be used under versatile conditions such as a vacuum atmosphere in which the inside of the furnace is pumped with a vacuum pump 16, an inert atmosphere in which nitrogen or argon is caused to flow from a gas feed port (piping) 17 into the furnace, a reduction atmosphere in which hydrogen or carbon monoxide is caused to flow into the furnace, and an oxidation atmosphere in which air atmosphere or oxygen is caused to flow into the furnace.
Nevertheless, in order to perform gas substitution, a high-strength pressure-tight tank is used as the outer tank since it is common practice to foremost perform vacuum pumping. Moreover, the internal bulkhead 12 is designed to be thinner than shown in Fig. 5 in order to facilitate the gas substitution and achieve a compact size. Thus, the pressure-tight tank is provided with a water-cooling function, but this caused the structure within the furnace and the peripheral structure to become complex, and resulted in high costs.

Accordingly, the melting of silicon in a conventional resistance heating furnace was based on the types shown in Fig. 3, Fig. 4, and Fig. 6, and, in order to prevent the oxidation of Si, the oxygen in the air atmosphere is pumped with a vacuum pump, and melting is performed by setting the oxygen partial pressure to roughly 0.14 Pa with a rotary pump, and normally lowered to roughly 0.03 Pa to 0.00002 Pa by concurrently using a mechanical booster pump and an oil spreading pump. Meanwhile, with the furnace shown in Fig. 5, the oxygen level is extremely high at approximately 21,000 Pa due to the air atmosphere, and this is no condition that allows the melting of silicon.

Meanwhile, the usage of silicon is not limited to a semiconductor silicon wafer or a substrate of crystalline silicon solar cells, and it is also used as a sputtering target. The usage of silicon as a sputtering target includes an antireflection film of the windshield of vehicles, and a light-absorbing layer or a protective layer which becomes the key to energy conversion efficiency for use in solar cells. Here, a silicon target for use as an antireflection film of windshields and a protective layer of solar cells does not necessarily require high performance as with polycrystalline silicon that is used as semiconductor wafers and solar cells.
Nevertheless, since demands are still low in this kind of field of sputtering targets, expensive monocrystalline silicon and polycrystalline silicon used in solar cells have been used conventionally.

If it is possible to inhibit the increase of impurities as much as possible in the melting process, there is a possibility that the silicon can be sufficiently utilized. Considerable growth is expected in the future for this usage also, and the supply of mass polycrystalline silicon at low cost is required.
By way of reference, the sputtering method is used as the means for forming thin films, but there are several sputtering methods including the DC sputtering method, the radio frequency sputtering method, and the magnetron sputtering method, and the thin film of various electronic components is being formed by leveraging the sputtering properties that are unique to the respective sputtering methods.

With the sputtering method, a substrate as the positive electrode and a target as the negative electrode are caused to face each other, and a high voltage is applied between the substrate and the target in an inert gas atmosphere so as to generate an electric field. Here, the ionized electrons and the inert gas collide to form plasma, the positive ions in the plasma collide with the surface of the target, the atoms configuring the target are thereby sputtered, and the sputtered atoms adhere to the opposing substrate surface and thereby form a film.

A molten silicon target is proposed as the foregoing sputtering target, but in view of the recent trends of enlarging the target, a thick and large rectangular or disk-shaped target is demanded in order to increase the deposition efficiency.
In any case, it is necessary to melt a silicon (Si) or silicon-based alloy as the raw material. Silicon is an easily oxidized element, and oxygen, when incorporated into the crystal, causes dislocated crystals, which are considered to result in device malfunctions and deterioration of conversion efficiency.
Thus, conventionally adopted was a method where, after completely eliminating air atmosphere components in the high vacuum furnace, the inert atmosphere is substituted in the foregoing highly airtight state or melting is performed as is in the vacuum state, and the melt is solidified in the same vacuum furnace.

As described above, equipment for melting a silicon or silicon-based alloy requires an airtight pressure tight case (furnace), and the furnace needs to be internally equipped with a heating unit, a cooling unit, various devices made from high heat-resistant and high-strength materials that are contamination-free for use in holding or transporting the melt, and a highly functional vacuum pump connected to the high-pressure vessel. Thus, there is a problem in that the production cost of the melting furnace is considerably high, and the equipment investment for production increase becomes costly. These costs will increase as the silicon target is enlarged.

Upon reviewing conventional technology, Patent Document 1 describes technology of blowing inert gas from above the silicon melt surface during crystallization and oscillating it to a degree where cavities are formed on the surface upon producing a crystalline silicon by applying a temperature gradient upward from the inner bottom face of the casting mold.
As with foregoing Patent Document 1, Patent Document 2 describes technology of disposing a gas supply lance made from an inner pipe and an outer pipe and supplying inert gas between these two pipes for covering the surface of the silicon melt, blowing inert gas from above the silicon melt surface during crystallization and oscillating it to a degree where cavities are formed on the surface upon producing a crystalline silicon by applying a temperature gradient upward from the inner bottom face of the casting mold.

In addition, Patent Document 3 describes adjusting the position of the tip of the gas supply pipe upon forming cavities on the surface by blowing inert gas from above the silicon melt surface. What is common among the technologies of these Patent Documents 1 to 3 is that inert gas is supplied to the surface, a configuration for shielding the melt surface with the inert gas is consequently required and, while they do not acknowledge the existence of oxygen in any way, there is no reference whatsoever regarding the oxygen partial pressure or the furnace body structure.
The technology of blowing inert gas from above the silicon melt surface during crystallization and oscillating it to a degree where cavities are formed on the surface upon producing a crystalline silicon by applying a temperature gradient upward from the inner bottom face of the casting mold in itself causes the structure to be complex, and the absolute necessity of a shield based on inert gas causes additional increase of costs.

Patent Document 1: Japanese Unexamined Patent Application Publication No. 2001-10810
Patent Document 2: Japanese Unexamined Patent Application Publication No. 2003-137525
Patent Document 3: Japanese Unexamined Patent Application Publication No. 2005-271078

### SUMMARY OF THE INVENTION

### [Problems to be Solved by the Invention]

An object of this invention is to provide an inexpensive furnace capable of melting a silicon or silicon-based alloy without hardly increasing the impurities in the raw material under conditions that do not even temporarily require a high vacuum, enable the procurement of a melting furnace, which was conventionally extremely expensive, at a considerably low cost, and thereby enable the production of a silicon or silicon-based alloy at low cost.

### [Means for Solving the Problem]

In order to achieve the foregoing object, the present inventors gave comprehensive consideration to achieve a melter (furnace) that does not require a pressure tight case, that does not require a high vacuum unit (pump), that does not include a cooling function of the furnace body, that includes a heating unit (heater) made of a material that will not cause contamination, and that does not require a high level of thermal resistance or a high-strength material. Based on the foregoing comprehensive consideration, the present inventors provide a device capable of achieving the foregoing object, and provide the following invention.

1) A method of melting a silicon or silicon-based alloy raw material, wherein a process from melting to solidifying the raw material is performed in an inert atmosphere with an oxygen partial pressure of 10 to 1000 Pa.
2) The method of melting a silicon or silicon-based alloy according to 1) above, wherein the process is performed in an inert atmosphere with an oxygen partial pressure of 10 to 300 Pa.
3) The method of melting a silicon or silicon-based alloy according to 1) or 2) above, wherein argon gas is introduced into a melting furnace to achieve an inert atmosphere.
4) The method of melting a silicon or silicon-based alloy according to any one of 1) to 3) above, wherein argon gas is introduced into and pumped from a melting furnace at a flow rate of 5 L/minute or more based on standard cubic centimeters per minute.

The present invention additionally provides the following invention.
5) A furnace for melting a silicon or silicon-based alloy raw material, comprising a structure which includes a heating element that generates heat via energization, and performs a process from melting the raw material with the heating elements to solidifying the raw material in an inert atmosphere with an oxygen partial pressure of 10 to 1000 Pa.
6) The furnace for melting a silicon or silicon-based alloy according to 5) above, wherein the heating element is a heater having MoSi₂ as its main component, and a board or a sleeve made of an Al₂O₃ or SiO₂-based ceramic fiber is used as an insulator material enclosing a crucible for melting the silicon or silicon-based alloy.
7) The furnace for melting a silicon or silicon-based alloy according to 5) or 6) above, wherein the melting furnace is configured from a first cabinet comprising a crucible for melting the silicon or silicon-based alloy and a heating element which encloses the crucible, and a second cabinet which encloses the first cabinet and has an airtight structure for blocking out outside air.

The present invention additionally provides the following invention.
8) The furnace for melting a silicon or silicon-based alloy according to any one of 5) to 7) above, wherein the first cabinet is configured from an insulator material that is designed so that a surface temperature of the first cabinet will be 250°C or lower when the furnace temperature is maintained at 1500°C.
9) The furnace for melting a silicon or silicon-based alloy according to any one of 5) to 8) above, wherein the first cabinet and the second cabinet are designed to have a clearance of 50 mm or more, and the second cabinet is without a cooling function.
10) The furnace for melting a silicon or silicon-based alloy according to any one of 5) to 9) above, wherein the crucible includes a function of changing its position relative to the heating element.
11) The furnace for melting a silicon or silicon-based alloy according to any one of 5) to 10) above, wherein a unit such as a motor including a raising and lowering function for changing the position of the crucible and the heating element is installed between the first cabinet and the second cabinet.

The present invention additionally provides the following invention.
12) The furnace for melting a silicon or silicon-based alloy according to any one of 5) to 11) above, wherein the first cabinet of the melting furnace has a structure of being divided into two chambers of an upper chamber and a lower chamber, and the upper chamber is a heating chamber comprising the heating element and the lower chamber is a cooling chamber that does not comprise the heating element.
13) The furnace for melting a silicon or silicon-based alloy according to any one of 5) to 12) above, wherein argon gas is respectively introduced into and pumped from the first cabinet and the second cabinet of the melting furnace based on standard cubic centimeters per minute.
14) The furnace for melting a silicon or silicon-based alloy according to any one of 5) to 13) above, wherein the crucible material is silica.

### [Effect of the Invention]

The present invention causes the inside of the melting furnace to be an inert gas atmosphere of argon or the like, but tolerates the existence of a reasonable level of oxygen partial pressure. Accordingly, a highly functional vacuum unit (pump) is not required. Consequently, it is possible to achieve a melter (furnace) that does not require a pressure tight case, and superior effects are yielded in that the production cost and operation cost of the device can be considerably reduced. Moreover, since a special cooling unit is not required in the melting furnace, there is an advantage in that the utility of the coolant is no longer required.

Since the heating unit (heater) is a heater that is prepared from MoSi₂, direct radiation heating is possible by installing the heater around the crucible, and heat can be effectively transferred. In addition, since most of the generated heat is sealed within the first cabinet, there is an advantage in that the device can be downsized. Moreover, high purity MoSi₂ can be used for the heater 2 that is prepared from MoSi₂, and effects are yielded in that contamination from the impurities contained in the heater is minimal, and the increase of impurities of the silicon or silicon-based alloy can be inhibited. In addition, since the high purity MoSi₂ used for preparing the heater is a substance possessing high oxidation resistance performance, there is an advantage in that the material will have a longer operating life in an oxygen partial pressure of 10 to 1000 Pa.

Meanwhile, a carbon heater that is generally used in conventional Si melting has a short life-span since oxidation will easily advance in an atmosphere of 10 to 1000 Pa.
Moreover, the SiO gas from the molten silicon or the residual oxygen will react with the carbon heater in the furnace and generate CO and CO₂. There is a drawback in that such CO or CO₂ blends in with the molten silicon and becomes incorporated into the crystals, whereby the carbon concentration is increased.

The present invention can resolve the foregoing drawbacks, and yields a further advantage in that the material of the second cabinet does not require a high level of thermal resistance or a high-strength material since the temperature of the first cabinet is sufficiently reduced, and the initial pumping for performing vacuum substitution is not conducted.
If the airtightness of an oxygen partial pressure of 1000 Pa or less is ensured, an effect is yielded in that it is possible to provide extremely cost-competitive production technology of being able to select a lightweight and inexpensive material for the second cabinet; for instance, materials such as a thin plate or a foil made of SUS or aluminum or acrylic or vinyl materials having a density of less than 1.5 g/cm³.
Accordingly, the present invention yields superior effects of significant cost reduction compared to conventional technology.

### BRIEF DESCRIPTION OF THE DRAWINGS

Fig. 1 is a horizontal cross section of the center part showing the outline of the melting furnace of the present invention.
Fig. 2 is a longitudinal cross section showing the outline of the melting furnace of the present invention.
Fig. 3 shows an example of a conventional resistance heating furnace, and is a cross section upon viewing this melting furnace from directly above.
Fig. 4 shows another example of a conventional vacuum melting furnace, and is a cross section upon viewing this melting furnace from directly above.
Fig. 5 shows an example of a conventional high-temperature air atmosphere furnace, and is a cross section upon viewing this melting furnace from directly above.
Fig. 6 shows an example of a conventional versatile melting furnace, and is a cross section upon viewing this melting furnace from directly above.

### DESCRIPTION OF EMBODIMENT

The silicon or silicon-based alloy melting furnace of the present invention heats the raw material with a heating element that generates heat via energization. Fig. 1 shows a horizontal cross section of the center part showing the outline of the melting furnace of the present invention. As described above, as the heating element, specifically used is a heater 2 produced from MoSi₂. Generally, a heater 2 produced from high purity MoSi₂ is used.
In the foregoing case, there are advantages in that the amount of heat generation of the heater 2 can be controlled, high temperature heating at 1400 to 1800°C is possible, and rapid heating is also possible. When using the heater 2 produced from high purity MoSi₂, since the generation of impurities that are volatilized from the heater 2 is minimal, a superior effect is yielded in that the silicon or silicon-based alloy can be melted to produce an ingot without hardly any contamination.

In the present invention, melting is performed in an inert atmosphere where the oxygen partial pressure of the melting furnace is 10 to 1000 Pa, but with this level of oxygen content, the heater 2 produced from MoSi₂ will not be damaged. Rather, the existence of oxygen works to inhibit the deterioration of the heater 2 produced from MoSi₂.
Compared to generally-used heaters made of carbon or high melting point metals such as tungsten, the heater 2 produced from high purity MoSi₂ is expensive. Nevertheless, heaters made of carbon or high melting point metals have a short life span since they become oxidized easily, and, when giving consideration to the fact that the destruction of the heater triggers contamination and the trouble of maintenance including the replacement of the heater, the heater produced from high purity MoSi₂ is advantageous in that cost reduction can be achieved in the long run.

The melting furnace is caused to be an inert atmosphere using argon gas. Generally, since a silicon or silicon-based alloy is strongly demanded of high purity due to its properties of becoming oxidized, there was a ready-made idea that, in the least, the inside of the melting furnace needs to be initially substituted to a high vacuum of roughly 0.00002 to 0.1 Pa, and that the melting needs to be performed in a vacuum or inert atmosphere having an oxygen partial pressure of roughly 0.01 to 0.1 Pa. Nevertheless, when melting was performed in an inert atmosphere having an oxygen partial pressure of 10 to 1000 Pa, which is higher compared to conventional technology by triple digits to quadruple digits, it was confirmed that, although the electrode surface of the molten silicon became oxidized, the oxidation does not progress any further. Moreover, the increase in oxygen of the silicon ingot inside the melting furnace was extremely low since the portion that was oxidized during the melting process moves to the surface.

The recognition of this fact is important. This fact was not conventionally recognized, and it could be said that this point became the basis for enabling the achievement of the present invention.
The melting furnace of the present invention can be confirmed from a first cabinet 3 comprising a crucible 1 for melting the silicon or silicon-based alloy and a heating element 2 which encloses the crucible, and a second cabinet 4 which encloses the first cabinet 3 and has an airtight structure for blocking out outside air. The double structured cabinet has the function of blocking outside air.
To being with, since the melting furnace itself does not need to be prepared from a pressure-resistant vessel as with conventional technologies, the cabinets are not configured to be excessively strong. However, as a result of adopting a double structure, it is possible to considerably improve the effect of reducing the engulfment of outside air and stably maintaining the oxygen partial pressure of the first cabinet 3 at a low level.

When a double structured cabinet is used, a cooling unit is not required under normal circumstances since the outer wall temperature of the first cabinet 3 is already 250°C or lower. Accordingly, the second cabinet 4 can be prepared from a material that mainly fulfills the role as a sealant and which maintains the oxygen partial pressure at a low level.
Moreover, the argon gas can be introduced into and pumped from the first cabinet 3 and the second cabinet 4 of the melting furnace respectively, at a flow rate of 5 L/minute or more based on standard cubic centimeters per minute via a piping 5.
More preferably, if the argon flow rate is individually adjusted and positive pressure is attained in order from the first cabinet 3, the second cabinet 4, and the outside (air atmosphere) of the second cabinet 4, an effect is yielded in that the amount of oxygen contained in the obtained ingot can be reduced since there will be no engulfment of air and the oxygen partial pressure in the furnace can be maintained at a low level.

The piping for introducing gas to the first cabinet and the second cabinet may be installed at a plurality of locations depending on the size of the furnace body. Table 1 shows the oxygen concentration measurement results around the melting crucible. When using the double structure cabinet and introducing argon gas (Ar) into the first cabinet and the second cabinet respectively, the change in the oxygen concentration was 21.0% (oxygen partial pressure of approximately 21000 Pa), which is the same as in the air atmosphere, at zero hours, 2.8% (oxygen partial pressure of 2840 Pa) at 10 minutes, and 0.2% (oxygen partial pressure 203 Pa) at 30 minutes, and it was possible to lower the oxygen partial pressure to the intended oxygen partial pressure. It was possible to control the oxygen concentration to 0.1% (oxygen partial pressure of 101 Pa) at 60 minutes, and similarly to 0.1 % even at 180 minutes.

Meanwhile, with the air atmosphere furnace shown in Fig. 5, when argon gas was introduced at 5 L/minute, the oxygen concentration was 16.1% (oxygen partial pressure of 16310 Pa) at 30 minutes and the rate of reduction was slow, and peaked at 12.3% (oxygen partial pressure of 12460 Pa) after the lapse of 180 minutes. With a conventional furnace, air was engulfed even when inert gas was introduced into the furnace, and it was nowhere near possible to control the oxygen partial pressure to be 1000 Pa or less.

[Table 1]

| Time of Ar Flow (min) | Fig. 1 | Fig. 5 |
|---|---|---|
| 0 | 21.0% | 21.0% |
| 10 | 2.8% | 19.4% |
| 30 | 0.2% | 16.1% |
| 60 | 0.1% | 13.9% |
| 120 | 0.1% | 12.7% |
| 180 | 0.1% | 12.3% |

In addition, with the melting furnace of the present invention, the crucible 1 may include a function of changing its position relative to the heating element 2. The longitudinal cross section of this example is shown in Fig. 2 The melting and cooling processes can be performed with a simple function of only moving the position of the crucible, as a result of causing the melting furnace to have a structure of being divided into two chambers of an upper chamber and a lower chamber, and using the upper chamber as the heating chamber 6 comprising a heating element and using the lower chamber as the cooling chamber 7 that does not comprise a heating element, for example. In the foregoing case, the first cabinet 3 is disposed vertically. The crucible 1, the piping 5, the heater 2, and the second cabinet 4 are the same as shown in Fig. 1. As a result of providing a vertical raising/lowering function (raising and lowering unit 8 shown in Fig. 2), unidirectional solidification is enabled, and it is possible to prepare an ingot that is free from shrinkage cavities and voids.

Under normal circumstances, silica is preferably is used as the material of the crucible 1. Here, since a carbon-based material is not used at all in the melting furnace, an effect is yielded in that the carbon concentration in the silicon ingot can be reduced compared to conventional melting furnaces.
Changes in the oxygen content and carbon content of the raw material before melting the silicon and the oxygen content and carbon content of the silicon ingot as a result of changing the oxygen partial pressure and melting the silicon are shown in Table 2. As shown in Table 2, the oxygen content can be inhibited based on the oxygen partial pressure so as to inhibit the increase of oxygen in the ingot. Meanwhile, it can be seen that there is no change in the carbon content at the time of the raw material and after the melting.

[Table 2]

| Condition of Si | Oxygen Content (ppm) | Carbon Content (ppm) |
|---|---|---|
| raw material before melting | 20 | 40 |
| ingot melt at oxygen partial pressure of 1,050ppm | 800 | 40 |
| ingot melt at oxygen partial pressure of 300 to 700ppm | 140 | 40 |
| ingot melt at oxygen partial pressure of 50 to 300ppm | 70 | 40 |

As described above, since the present invention only requires the maintenance of a certain level of airtightness, there is an advantage in that the melting equipment can be configured at an unparalleled low cost as a result of enabling the selection of inexpensive materials that are not demanded of heat resistance or high strength.
In addition, the present invention can be easily enlarged. When enlarging conventional melting furnaces, they needed to be designed to have even greater thickness so as to withstand the pressure from the high vacuum in the furnace, and this led to high costs. Moreover, in the case of induction heating, higher costs were required for enlarging the heater to act as the coil. The present invention yields an effect of being able to reduce the amount of equipment investment immensely.

A specific example of using the double structured cabinet of the present invention is now explained.
When the furnace body of the melting furnace adopts a single (cabinet) structure, since the inside of the furnace body is entirely substituted even when substitution is performed for long hours via the flow of argon gas, there were many cases where residual oxygen around the furnace body would become engulfed. Consequently, there was a problem in that it is difficult to achieve an oxygen partial pressure of 1000 Pa or less. In the foregoing case, the amount of oxygen in Si exceeds 800 ppm, and it is difficult to attain the goal of reducing the oxygen in Si.

In order to overcome the foregoing drawback, a double structured furnace body was adopted for the melting furnace. As a result of causing argon to flow to the inner tank (first cabinet 3) and the outer tank (second cabinet 4) respectively, via the piping 5, the oxygen partial pressure around the crucible 1 was considerably reduced. The first cabinet and the second cabinet respectively have an airtight structure of blocking outside air, but it should be easy to understand that they do not need to possess airtightness of the same level as a vacuum case since it will suffice only if a state where the air atmosphere is not engulfed can be maintained since argon is introduced.

Since the inside of the pressure tight case is not caused to be a vacuum with a vacuum pump and substituted with argon as with the conventional technology, the lower limit of the oxygen partial pressure in the present invention was 10 Pa.
When silicon was melted at an oxygen partial pressure of 300 to 700 Pa, the oxygen in the ingot was 140 ppm. Moreover, when silicon was melted at an oxygen partial pressure of 10 to 300 Pa, the oxygen in the ingot was 70 ppm. The oxygen reduction effect in the silicon was confirmed as described above.

Moreover, the first cabinet is configured from an insulator material that is designed so that the surface temperature of the first cabinet will be 250°C or lower when the furnace temperature is maintained at 1500°C. Furthermore, the first cabinet and the second cabinet are designed to have a clearance of 50 mm or more. With this kind of double structure, it should be easy for a person skilled in the art to understand that, consequently, the second cabinet no longer requires a cooling function.

This kind of silicon ingot sufficiently satisfies the specification as a sputtering target. In addition, if the oxygen partial pressure is constantly controlled to be a low pressure, there is potential for application in crystalline silicon solar cells. Moreover, as a result of using a silica (SiO₂)-based crucible, the increase of carbon impurities could not be acknowledged.

### INDUSTRIAL APPLICABILITY

The present invention causes the inside of the melting furnace to be an inert gas atmosphere of argon or the like, tolerates the existence of a reasonable level of oxygen partial pressure, and does not require a highly functional vacuum unit (pump). Consequently, it is possible to achieve a melter (furnace) that does not require a pressure tight case, and superior effects of being able to significantly reduce the production cost and operation cost of the device are yielded.
Moreover, there is also an advantage in that a special cooling unit is not required in the melting furnace. Moreover, since the heating unit (heater) is a heater produced from MoSi₂, direct heating is possible by disposing the heater around the crucible, and there is an advantage in that the entire furnace does not need to be heated. Moreover, high purity MoSi₂ can be used for the heater produced from MoSi₂, and there is an effect that, since the generation of impurities that are volatilized from the heater is minimal, the silicon or silicon-based alloy can be melted to produce an ingot without hardly any contamination.

Moreover, since MoSi₂ is a substance possessing high oxidation resistance performance, there is an advantage in that the material will have a longer operating life. In addition, the heat transfer efficiency is high based on the heating method by the heater produced from MoSi₂ disposed around the crucible, and, since the temperature can be sufficiently lowered with the first cabinet and initial pumping is not performed for vacuum substitution, a cost reduction effect is yielded in that the second cabinet material does not need to be a highly heat-resistant or high-strength material.
Since silicon or silicon-based alloy materials that are being enlarged can be produced at fairly low cost, the present invention is extremely useful industrially.

## Claims

1. A method of melting a silicon or silicon-based alloy raw material, wherein a process from melting to solidifying the raw material is performed in an inert atmosphere with an oxygen partial pressure of 10 to 1000 Pa.

2. The method of melting a silicon or silicon-based alloy according to claim 1, wherein the process is performed in an inert atmosphere with an oxygen partial pressure of 10 to 300 Pa.

3. The method of melting a silicon or silicon-based alloy according to claim 1 or claim 2, wherein argon gas is introduced into a melting furnace to achieve an inert atmosphere.

4. The method of melting a silicon or silicon-based alloy according to any one of claims 1 to 3, wherein argon gas is introduced into and pumped from a melting furnace at a flow rate of 5 L/minute or more based on standard cubic centimeters per minute.

5. A furnace for melting a silicon or silicon-based alloy raw material, comprising a structure which includes a heating element that generates heat via energization, and performs a process from melting the raw material with the heating elements to solidifying the raw material in an inert atmosphere with an oxygen partial pressure of 10 to 1000 Pa.

6. The furnace for melting a silicon or silicon-based alloy according to claim 5, wherein the heating element is a heater having MoSi₂ as its main component, and a board or a sleeve made of an Al₂O₃ or SiO₂-based ceramic fiber is used as an insulator material enclosing a crucible for melting the silicon or silicon-based alloy.

7. The furnace for melting a silicon or silicon-based alloy according to claim 5 or claim 6, wherein the melting furnace is configured from a first cabinet comprising a crucible for melting the silicon or silicon-based alloy and a heating element which encloses the crucible, and a second cabinet which encloses the first cabinet and has an airtight structure for blocking out outside air.

8. The furnace for melting a silicon or silicon-based alloy according to any one of claims 5 to 7, wherein the first cabinet is configured from an insulator material that is designed so that a surface temperature of the first cabinet will be 250°C or lower when the furnace temperature is maintained at 1500°C.

9. The furnace for melting a silicon or silicon-based alloy according to any one of claims 5 to 8, wherein the first cabinet and the second cabinet are designed to have a clearance of 50 mm or more, and the second cabinet is without a cooling function.

10. The furnace for melting a silicon or silicon-based alloy according to any one of claims 5 to 9, wherein the crucible includes a function of changing its position relative to the heating element.

11. The furnace for melting a silicon or silicon-based alloy according to any one of claims 5 to 10, wherein a unit such as a motor including a raising and lowering function for changing the position of the crucible and the heating element is installed between the first cabinet and the second cabinet.

12. The furnace for melting a silicon or silicon-based alloy according to any one of claims 5 to 11, wherein the first cabinet of the melting furnace has a structure of being divided into two chambers of an upper chamber and a lower chamber, and the upper chamber is a heating chamber comprising the heating element and the lower chamber is a cooling chamber that does not comprise the heating element.

13. The furnace for melting a silicon or silicon-based alloy according to any one of claims 5 to 12, wherein argon gas is respectively introduced into and pumped from the first cabinet and the second cabinet of the melting furnace based on standard cubic centimeters per minute.

14. The furnace for melting a silicon or silicon-based alloy according to any one of claims 5 to 13, wherein the crucible material is silica.
